(19) Europäisches Patentamt
European Patent Office
Office européen des brevets

(11) **EP 1 001 538 A2**

(12) **EUROPÄISCHE PATENTANMELDUNG**

(43) Veröffentlichungstag:
**17.05.2000  Patentblatt 2000/20**

(51) Int. Cl.[7]: **H03M 3/02**

(21) Anmeldenummer: **99114923.8**

(22) Anmeldetag: **30.07.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **10.11.1998 DE 19851637**

(71) Anmelder: **ROBERT BOSCH GMBH
70442 Stuttgart (DE)**

(72) Erfinder: **Steinlechner, Siegbert
71229 Leonberg (DE)**

(54) **Sigma-Delta-Modulator und Verfahren zur Unterdrückung eines Quantisierungsfehlers in einem Sigma-Delta-Modulator**

(57)    Sigma-Delta-Modulator zur Umwandlung eines analog oder digital vorliegenden, niederfrequenten Eingangssignals (X) hoher Auflösung in ein quantisiertes Analog- oder Digitalsignal (Y), mit einer Fehlerrückkoppelschaltung zur Unterdrückung von Quantisierungsfehlern, wobei er Mittel ($Z^{-1}$) zur Verzögerung des Eingangssignals (X) um i Abtastperioden zum Erhalt verzögerter Eingangssignale ($X_i$), wobei i=1,2,...n ist, Mittel (2) zur Addition der um i Abtastperioden verzögerten Eingangssignale ($X_i$) zum Erhalt eines Summensignals ($S_1$), Mittel (Q, $Q_0$, $Q_1$ bis $Q_n$, 3) zur Erzeugung quantisierter, um i Abtastperioden verzögerter Eingangssignale ($VZ_i$) und zur Addition der verzögerten, quantisierten Eingangssignale ($VZ_i$) zum Erhalt eines zweiten Summensignals ($S_2$), und Mittel (1) zur Subtraktion der Summensignale ($S_1$) und ($S_2$) von einem aktuellen Wert des Eingangssignals (X) aufweist.

FIG. 1

EP 1 001 538 A2

**EP 1 001 538 A2**

**Beschreibung**

Die vorliegende Erfindung betrifft einen Sigma-Delta-Modulator nach dem Oberbegriff des Patentanspruchs 1 sowie ein Verfahren zur Unterdrückung eines Quantisierungsfehlers in einem Sigma-Delta-Modulator nach dem Oberbegriff des Patentanspruchs 5.

Sigma-Delta-Modulatoren wandeln niederfrequente Signale hoher Auflösung, welche in analoger oder digitaler Form vorliegen können, in abgetastete, grob quantisierte Signale mit relativ hoher Abtastrate um. Diese Ausgangssignale können ebenfalls in analoger oder digitaler Form bereitgestellt werden. Durch die grobe Quantisierung (oftmals wird nur ein Bit zur Quantisierung verwendet) entsteht ein Quantisierungsrauschen. Es wird angestrebt, dieses Rauschen durch Fehlerrückkopplung so zu formen, daß das Rauschspektrum in dem interessierenden niederfrequenten Bereich (Frequenzbereich des Eingangssignals) sehr klein ist, bei höheren Frequenzen jedoch ansteigt. Durch eine Tiefpassfilterung läßt sich hochfrequentes Rauschen anschließend weitgehend beseitigen.

Sigma-Delta-Modulatoren können beispielsweise als Analog/Digital-Wandler (A/D-Wandler) eingesetzt werden: Hierbei wird ein analoges Eingangssignal in eine hochfrequente Digitalfolge mit der Wertigkeit von beispielsweise ± 1 umgewandelt. Umgekehrt ist auch der Einsatz eines Sigma-Delta-Modulators als Digital/Analog-Wandler (D/A-Wandler) möglich. Hierbei weist das digitale Eingangssignal beispielsweise eine Wortbreite von 16 Bit mit einer Abtastrate von beispielsweise 48 kHz auf. Das Ausgangssignal kann beispielsweise eine hochfrequente Folge diskreter analoger Werte (beispielsweise ± 1 Volt mit einer Abtastrate von 1 MHz) sein. Sigma-Delta-Modulatoren können ferner als Digital/Digital-Wandler (D/D-Wandler) eingesetzt werden, welche eine digitale Folge hoher Auflösung (beispielsweise 16 Bit) und niedriger Abtastrate (beispielsweise 48 kHz) in eine digitale Folge niedriger Auflösung (z.B. 1 Bit) und hoher Abtastrate (z.B. 1 MHz) umformen. Eine Anwendung für einen derartigen D/D-Wandler ist beispielsweise in der DE-A-198 19 069 beschrieben. In dieser Druckschrift wird dargestellt, wie mit Hilfe eines rein digitalen Sigma-Delta-Modulators die Multiplikation eines Analogsignals mit einem digital vorliegenden Signal erfolgen kann. Dieses Prinzip wird dort zur Auswertung von analogen Sensorsignalen eingesetzt. Sigma-Delta-Modulatoren 2. Ordnung mit Ein-Bit-Quantisierung sind beispielsweise in dem Artikel "A Use of Double Integration in Sigma Delta Modulation", J. Candy, IEEE, Transactions on Communications, März 1985, beschrieben. Der dort beschriebene Modulator besteht aus einem Modulator 1.

Ordnung, welchem eine weitere Rückkopplungsschleife hinzugefügt ist. Es wird darauf hingewiesen, daß die Hinzunahme weiterer Rückkoppelschleifen zur Erhöhung des Modulatorgrades (Grad ≥ 3) im Falle von 1-Bit-Quantisierungen zu nicht stabilen Strukturen führt.

In "Theory and Practical Implementation of a Fifth-Order Sigma-Delta A/D-Converter", R.W. Adams et al., J. Audio Eng. Soc., Vol. 39, Nr. 7/8, 1991 sind Topologien beschrieben, die bei geeigneter Dimensionierung stabile Sigma-Delta-Modulatoren mit 1-Bit-Quantisierung gewährleisten. Der genannte Artikel betrifft beispielsweise einen A/D-Wandler mit Sigma-Delta-Modulator 5. Ordnung und einer 1-Bit-Quantisierung.

Sigma-Delta-Modulatoren können auch zu anderen Zwecken als zur A/D- bzw. D/A-Wandlung verwendet werden. In "IIR Filtering on Sigma-Delta modulated Signals", D.A. Johns et al, Electronics Letters 14. Februar 1991, Vol. 27, Nr. 4 ist beispielsweise der Einsatz mehrerer rein digitaler Sigma-Delta-Modulatoren im Inneren eines IIR-Filters beschrieben. In "Nonlinear Arithmetic Operations on the Delta Sigma Pulse Stream", M. Freeman et al, Signal Processing 21 (1990) Seiten 25-35, Elsevier Science Publishers, ist die Anwendung nicht linearer Operationen auf den Datenstrom eines Sigma-Delta-Modulators beschrieben.

Aufgabe der Erfindung ist die Schaffung eines Sigma-Delta-Modulators, bei dem ein Quantisierungsfehler bzw. Quantisierungsrauschen in wirksamer Weise unterdrückt werden kann.

Diese Aufgabe wird gelöst durch einen Sigma-Delta-Modulator zur Umwandlung eines analog oder digital vorliegenden niederfrequenten Eingangssignals hoher Auflösung in ein quantisiertes Analog- oder Digitalsignal, mit einer Fehlerrückkoppelschaltung zur Unterdrückung von Quantisierungsfehlern, welcher dadurch gekennzeichnet ist, daß er Mittel zur Verzögerung des Eingangssignals X um i Abtastperioden zum Erhalt verzögerter Eingangssignale $X_i$, wobei i = 1, 2, ... n ist, Mittel zur Addition der um i Abtastperioden verzögerten Eingangssignale $X_i$ zum Erhalt eines Summensignals $S_1$, Mittel zur Erzeugung quantisierter, um i Abtastperioden verzögerter Eingangssignale $VZ_i$ und zur Addition der verzögerten, quantisierten Eingangssignale $VZ_i$ zum Erhalt eines zweiten Summensignals $S_2$, und Mittel zur Subtraktion der Summensignale $S_1$ und $S_2$ von einem aktuellen Wert des Eingangssignals X aufweist. Entsprechend einer gewünschten Ordnung des Sigma-Delta-Modulators kann der Wert n beispielsweise zwischen 1 und 20 liegen. Auch andere Werte sind denkbar, beispielsweise n = 5. Gute Ergebnisse lassen sich z.B. auch bei einem Sigma-Delta-Modulator 3. Ordnung (n=3) erzielen. Mit dem erfindungsgemäßen Sigma-Delta-Modulator ist eine sehr wirksame Unterdrückung von Quantisierungsrauschen zur Verfügung gestellt.

Die Aufgabe wird ferner gelöst durch ein Verfahren zur Unterdrückung eines Quantisierungsfehlers bei der Umwandlung eines analog oder digital vorliegenden niederfrequenten Eingangssignals X hoher Auflösung in ein quantisiertes Analog- oder Digitalsignal Y in einem eine Fehlerrückkoppelschaltung aufweisenden Sigma-Delta-Modulator, welches die folgenden Schritte aufweist:

Quantisierung des Eingangssignals X entsprechend einer Abtastrate $f_A$ zu Zeitpunkten t = m • Ta , wobei m = 0,1,2 ... und Ta die Abtastperiode des Sigma-Delta-Modulators ist, Verzögerung des Eingangssignals um i Abtastperioden, wobei i = 1,2 ... n ist, zum Erhalt verzögerter Eingangssignale $X_i$, Addition der um i Abtastperioden verzögerten Eingangssignale $X_i$ zum Erhalt eines ersten Summensignals $S_1$, Erzeugung quantisierter, um i Abtastperioden verzögerter Eingangssignale $VZ_i$ und Addition der verzögerten, quantisierten Eingangssignale $VZ_i$ zum Erhalt eines zweiten Summensignals $S_2$, und Subtraktion der Summensignale $S_1$ und $S_2$ von einem aktuellen Wert des Eingangesignals X.

Vorteilhafte Ausgestaltungen des erfindungsgemäßen Sigma-Delta-Modulators und des erfindungsgemäßen Verfahrens sind Gegenstand der Unteransprüche.

Gemäß einer vorteilhaften Ausgestaltung des Sigma-Delta-Modulators weist dieser Mittel zur Multiplikation der um i Abtastperioden verzögerten Eingangssignale $X_i$ jeweils mit Koeffizienten $d_i$ einer Übertragungsfunktion, so daß das erste Summensignal $S_1$ in der Form $S_1 = \Sigma d_i X_i$ darstellbar ist, und Mittel zur Multiplikation der um i Abtastperioden verzögerten und quantisierten Eingangssignale $Vz_i$ jeweils mit Koeffizienten $c_i$ der Übertragungsfunktion, so daß das zweite Summensignal $S_2$ in der Form $S_2 = \Sigma c_i Vz_i$ darstellbar ist, auf. Die Übertragungsfunktion des erfindungsgemäßen Sigma-Delta-Modulators ist beispielsweise in der Form

$$Y(z)=X(z) \cdot \frac{a_o}{1+(c_1+d_1) \cdot z^{-1}+(c_2+d_2) \cdot z^{-2}+...+(c_n+d_n) \cdot z^{-n}} +E(z)$$

$$\cdot \frac{1+d_1 \cdot z^{-1}+d_2 \cdot z^{-2}+...d_n \cdot z^{-n}}{1+(c_1+d_1) \cdot z^{-1}+(c_2+d_2) \cdot z^{-2}+...+(c_n+d_n) \cdot z^{-n}}$$

$$(1)$$

darstellbar. Die Übertragungsfunktion des Systems ist hier mit Hilfe der Z-Transformation dargestellt. Z ist hierbei eine Frequenzvariable zur Darstellung der Übertragungsfunktion im Frequenzraum. X(Z) bzw. Y(Z) sind die Z-Transformierten (Frequenzspektren) des Eingangssignals X bzw. des Ausgangssignals Y. E(Z) bezeichnet die Z-Transformierte (Frequenzspektrum) der Rauschübertragung. Der hierbei auftretende Quantisierungsfehler e ist als Differenz zwischen Eingangs-und Ausgangssignals eines entsprechenden Quantisierers definiert. Durch die erfindungsgemäß durchführbare Wahl der Koeffizienten $c_i$ und $d_i$ lassen sich Zähler und Nenner der Rauschübertragungsfunktion (Faktor bei E(z)) und der Nenner der Signalübertragungsfunktion (Faktor bei X(z)) einstellen. In der Regel wird die Signalübertragungsfunktion als Tiefpass, die Rauschübertragungsfunktion als Hochpass dimensioniert, wodurch das resultierende Rauschen im Ausgangssignal Y im niederfrequenten Bereich (d.h. im Frequenzbereich des Eingangssignals X) sehr klein gehalten werden kann.

Vorteilhafterweise weist der Sigma-Delta-Modulator gemäß der vorliegenden Erfindung Mittel zur Ablegung bzw. Speicherung der $2^n$ möglichen Zustände des zweiten Summensignals $S_2$ entsprechend der Übertragungsfunktion und der Wahl der Koeffizienten $c_i$ auf, so daß ein konkreter Zustand ohne die Notwendigkeit einer expliziten Summenbildung erkennbar ist und als entsprechendes Summensignal $S_2$ ausgebbar ist. Da die quantisierten Signale $Vz_1...Vz_n$ (jeweils ± 1) nur $2^n$ verschiedene Zustände annehmen können, ist hiermit gewährleistet, daß die zu bildende Summe $\Sigma Vz_i c_i$ nicht in jedem Abtastschritt neu berechnet werden muß. Vielmehr können alle möglichen $2^n$ verschiedenen Ergebnisse vorher berechnet und in geeigneter Weise abgelegt werden. Durch die Einsparung von Multiplikations- und Additionsoperationen ist der Rechenaufwand gegenüber herkömmlichen Sigma-Delta-Modulatoren wesentlich vermindert.

Die Erfindung wird nun anhand der beigefügten Zeichnung im einzelnen beschrieben. In dieser zeigt

Figur 1     ein schematisches Blockschaltbild eines erfindungsgemäßen Sigma-Delta-Modulators n-ter Ordnung,

Figur 2     ein schematisches Blockschaltbild der Struktur eines erfindungsgemäßen Sigma-Delta-Modulators mit getrennter Verzögererkette für das quantisierte Signal,

Figur 3     ein schematisches Blockschaltbild einer Anwendung des erfindungsgemäßen Sigma-Delta-Modulators als A/D-Wandler,

Figur 4     ein schematisches Blockschaltbild einer Anwendung des erfindungsgemäßen Sigma-Delta-Modulators als D/D-Wandler, und

Figur 5     ein schematisches Blockschaltbild einer Anwendung des erfindungsgemäßen Sigma-Delta-Modulators als D/A-Wandler.

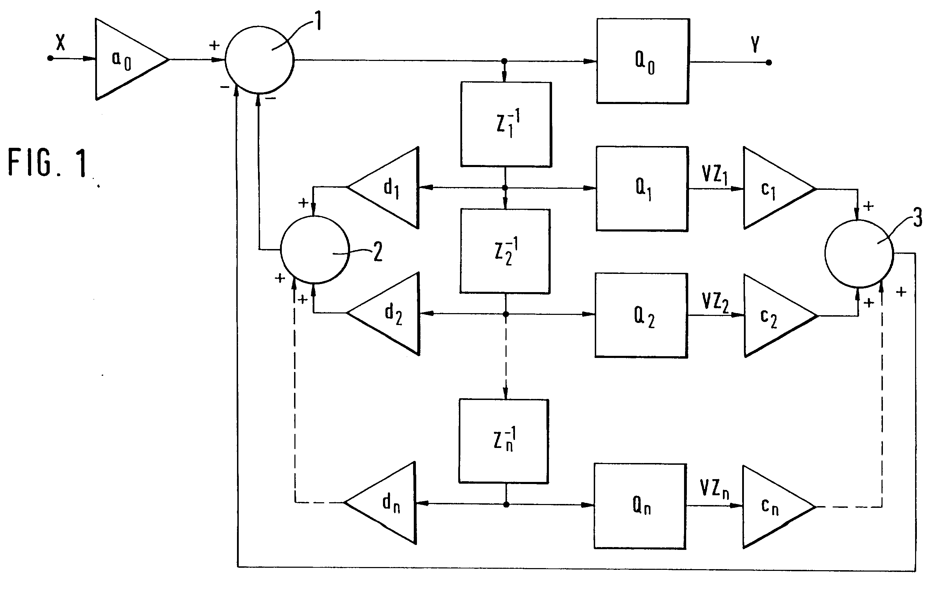

In Figur 1 ist die Grundstruktur des erfindungsgemäßen Sigma-Delta-Modulators n-ter Ordnung dargestellt.

Hierbei stellt X das analoge oder digitale Eingangssignal und Y das analoge oder digitale quantisierte Ausgangssignal zum diskreten Zeitpunkt $m \cdot Ta$ ($m = 0,1,2...$) dar. Mit Ta ist die Abtastperiode des Sigma-Delta-Modulators bezeichnet.

Die Dreiecke stellen Mittel zur Multiplikation eines Signals mit den jeweils eingetragenen Koeffizienten $c_i d_i$ dar (Multiplizierglieder). Der Einfachheit halber werden im folgenden die Multiplizierglieder mittels der ihnen zugeordneten Koeffizienten bezeichnet. Die Kreise 1, 2, 3 bezeichnen Summierglieder. $Z^{-1}$ ist die Kennzeichnung einer Verzögerung um eine Abtastperiode Ta.

Mit $Q_0...Q_n$ sind Quantisierer bezeichnet, welche ein Eingangssignal grob quantisieren. Die Quantisierung erfolgt üblicherweise auf nur zwei mögliche Werte, beispielsweise $\pm 1$ im Falle eines digitalen Quantisierers, oder auf $\pm U_{ref}$ im Falle eines analogen Quantisierers und einer Referenzspannung $U_{ref}$, welche beispielsweise 1 Volt betragen kann.

Die Übertragungsfunktion des Systems mit Hilfe der Z-Transformation ist in der Form

$$Y(z) = X(z) \cdot \frac{a_o}{1+(c_1+d_1) \cdot z^{-1}+(c_2+d_2) \cdot z^{-2}+...+(c_n+d_n) \cdot z^{-n}} + E(z) \cdot \frac{1+d_1 \cdot z^{-1}+d_2 \cdot z^{-2}+...d_n \cdot z^{-n}}{1+(c_1+d_1) \cdot z^{-1}+(c_2+d_2) \cdot z^{-2}+...+(c_n+d_n) \cdot z^{-n}}$$

(1)

darstellbar. Hierbei sind, wie bereits oben erläutert, $X(z)$ bzw. $Y(Z)$ die Spektren bzw. z-Transformierten des Eingangssignals X bzw. des Ausgangssignals Y. $E(Z)$ bezeichnet die Z-Transformierte des vom obersten Quantisierer $Q_1$ verursachten Quantisierungsfehlers $e(m \cdot Ta)$. Als Quantisierungsfehler wird die Differenz zwischen Eingangs- und Ausgangssignal eines Quantisierers bezeichnet.

Durch entsprechende Wahl der Koeffizienten $c_i$ und $d_i$ kann eine geeignete Form der Übertragungsfunktion (1) erzeugt werden.

Das Eingangssignal X wird zunächst mit dem Koeffizienten $a_0$ multipliziert. Anschließend wird das Signal zum Erhalt des Ausgangssignals Y einem Quantisierer $Q_0$ zugeführt. Das dem Quantisierer $Q_0$ zugeführte Signal ist mittels einer Fehlerrückkopplungsschaltung modifizierbar. Die Fehlerrückkopplungsschaltung weist Verzögerungsglieder $Z^{-1}$, weitere Quantisierer $Q_1$ bis $Q_n$, sowie die als Dreiecke dargestellten Multiplizierglieder 1, 2, 3 zur Multiplikation mit Koeffizienten $c_1$ bis $c_n$ und $d_1$ bis $d_n$ der Übertragungsfunktion $Y(Z)$ auf. Nach Verzögerung mittels eines ersten Verzögerungsgliedes $Z^{-1}$ wird ein Eingangssignalwert X als verzögerter Wert $X_1$, einem Multiplizierglied $d_1$, einem weiteren Verzögerungsglied $Z^{-1}$ und einem zweiten Quantisierer $Q_1$ zugeführt. Das zweite Verzögerungsglied $Z^{-1}$ führt entsprechend ein um zwei Abtastperioden verzögertes Eingangssignal $X_2$ einem zweiten Multiplizierglied $d_2$, einem weiteren Verzögerungsglied $Z^{-1}$ und einem weiteren Quantisierer $Q_2$ zu. Entsprechend der Ordnung des Sigma-Delta-Modulators erfolgt eine entsprechende Verzögerung und Weiterleitung des Eingangssignals bis zu einem n-ten Verzögerungsglied $Z^{-1}$.

Die jeweils mit Koeffizienten $d_1$ bis $d_n$ multiplizierten verzögerten Eingangssignale $X_i$ werden dem Summierglied 2 zugeführt, in dem die Summe $\Sigma d_i X_i$ gebildet wird.

Die verzögerten Eingangssignale $X_i$ werden ferner den Quantisierern $Q_1$ bis $Q_n$ zugeführt. In den Quantisierern $Q_1$ bis $Q_n$ erfolgt jeweils eine grobe Quantisierung der verzögerten Eingangssignale $X_i$.

Üblicherweise stellen die Ausgänge der Quantisierer $Q_1$ bis $Q_n$ die Vorzeichen $VZ_1$ bis $VZ_n$ ihrer Eingänge dar. Die Ausgänge $VZ_1$ bis $VZ_n$ werden jeweils mit Koeffizienten $c_1$ bis $c_n$ multipliziert. Diese Produkte werden einem Summierglied 3 zur Bildung der Summe $\Sigma c_i VZ_i$ zugeführt.

Die in den Summiergliedern 2 und 3 ermittelten Summen werden dem Summierglied 1 zugeführt, und dort von dem aktuellen Wert des Eingangssignals X subtrahiert.

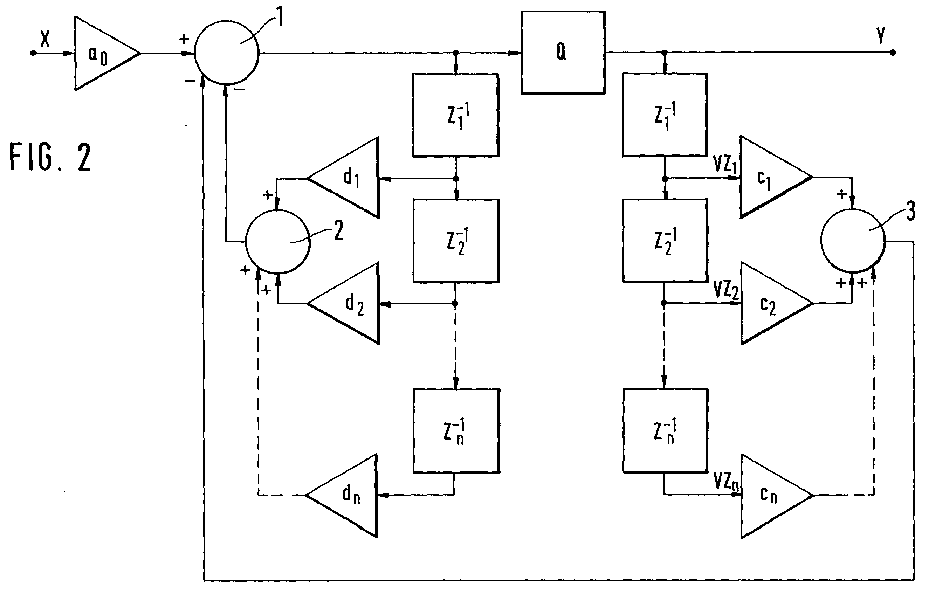

In Figur 2 ist eine weitere Ausführungsform des erfindungsgemäßen Sigma-Delta-Modulators dargestellt. Die Ausführungsform der Figur 2 stellt eine alternative, äquivalente Realisierung zur Ausführungsform der Figur 1 dar, bei der jedoch nur ein Quantisierer Q vorgesehen ist.

Ferner ist eine getrennte Verzögererkette für das quantisierte Signal vorgesehen. Die Signalübertragung bzw. die Fehlerrückkopplung erfolgt analog zur Ausführungsform der Figur 1.

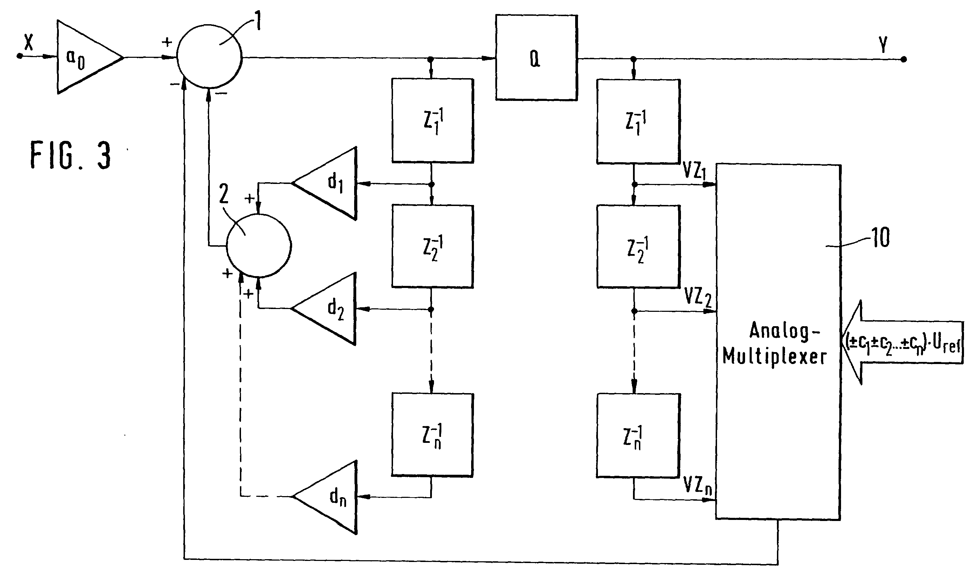

Bei der Ausführungsform des Sigma-Delta-Modulators gemäß Figur 3 ist das Eingangssignal X ein Analogsignal. Somit sind die Summierer 1, 2, die Multiplizierglieder $a_0$, $d_1$ bis $d_n$, und die linke Verzögererkette mit Verzögerungsgliedern $Z^{-1}$ in Analogtechnik ausgeführt. Analoge Verzögererketten werden nach dem Stand der Technik üblicherweise in SC-Technik (Switched Capacitor) realisiert. Der Quantisierer Q kann beispielsweise als Komparator ausgeführt sein, der an seinem Ausgang ein digitales Signal liefert. Dieses Digitalsignal hat bei 1-Bit-Quantisierung beispielsweise die Zustände +1 (Komparator-Eingangssignal $\geq 0$) und -1 (Komparator-Eingangssignal $< 0$) und beschreibt damit das Vorzeichen VZ des Eingangssignals. Die rechte Verzögererkette mit Verzögerungsgliedern $Z^{-1}$ ist digital aus-

gebildet (beispielsweise 1-Bit breit).

Ein besonderer Vorteil der in dem erfindungsgemäßen Sigma-Delta-Modulator realisierten Struktur besteht darin, daß die quantisierten Signale $VZ_1...VZ_n$ (jeweils $\pm$ 1) nur $2^n$ verschiedene Zustände annehmen können. Die gemäß der in den Figuren 1 und 2 dargestellten Grundstruktur zu bildende Summe $\Sigma c_i VZ_i$ muß erfindungsgemäß nicht in jedem Abtastschritt neu berechnet werden. Es ist vielmehr ausreichend, alle möglichen $2^n$ verschiedene Ergebnisse entsprechend der gewählten $c_i$ vorher zu berechnen und in geeigneter Weise abzulegen. Hierdurch können Multiplikationen und Additionen gegenüber bekannten Realisierungen eingespart werden. Im Falle des A/D-Wandlers der Figur 3 wird dies durch einen Analogmultiplexer 10 realisiert, der n digitale Steuereingänge $VZ_1...VZ_n$ besitzt und an seinem Ausgang jeweils eine von $2^n$ Analogspannungen ausgibt. Die Analogspannungen werden aus Referenzspannungen $\pm$ $U_{ref}$ (z.B. $\pm$ 1 Volt) durch passive Spannungsteilernetze in an sich bekannter Weise gewonnen. Die notwendigen Analogspannungen sind hierbei $(\pm c_1 \pm c_2 \pm ... \pm c_n) \cdot U_{ref}$, entsprechend den gewählten Koeffizienten $c_i$ der Übertragungsfunktion Y(Z).

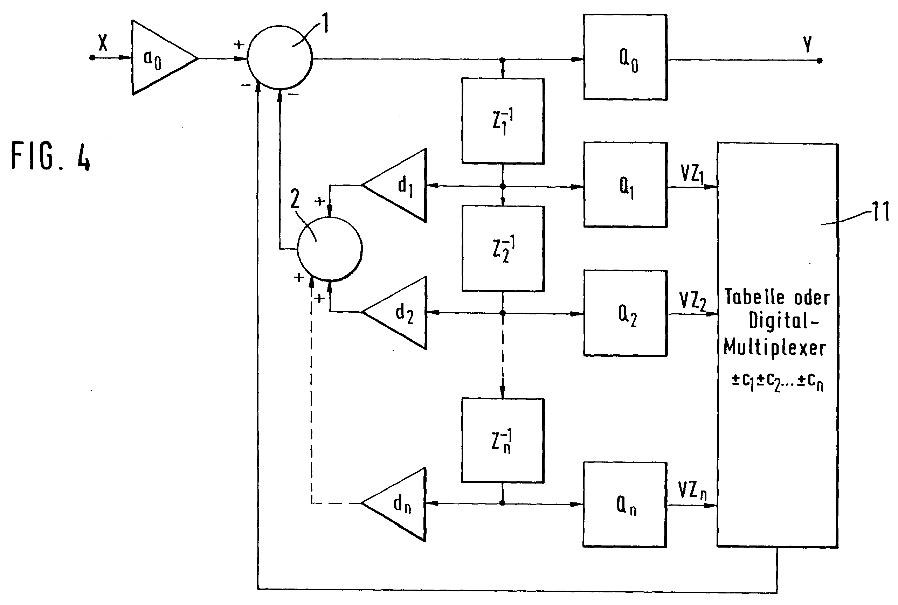

In Figur 4 ist ein D/D-Wandler dargestellt, bei dem sämtliche Elemente digital realisiert sind. Gemäß der Struktur des Sigma-Delta-Modulators der Figur 4 ist eine Mehrzahl von Quantisierern $Q_0...Q_n$ vorgesehen. Diese Quantisierer führen zu keinem zusätzlichen Schaltungsaufwand, da es ausreichend ist, ein Signal hoher Wortbreite (beispielsweise 16 Bit) dadurch zu quantisieren, daß nur das höchstwertige Bit (Vorzeichenbit in der Zweierkomplement-Darstellung) weiter verarbeitet wird. Die Bereitstellung der $2^n$ digitalen Werte $\pm c_1 \pm c_2 \pm ... \pm c_n$ erfolgt hier beispielsweise durch eine Tabelle, welche beispielsweise als ROM ausgeführt sein kann, oder über einen Digitalmultiplexer 11, an dessen Eingänge die oben erläuterten digitalen Werte $VZ_i$ angelegt werden.

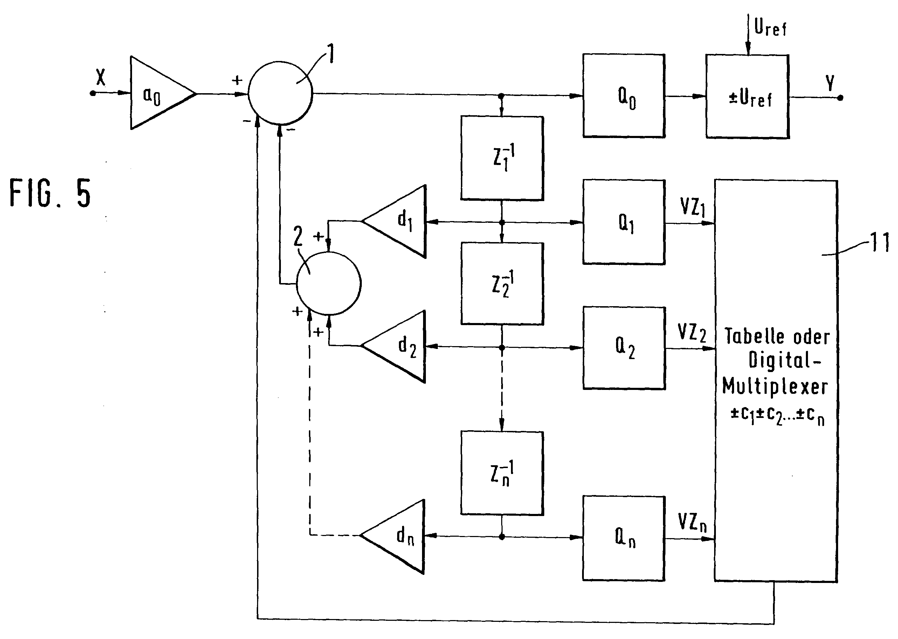

In Figur 5 ist die Anwendung eines erfindungsgemäßen Sigma-Delta-Modulators als D/A-Wandler dargestellt. Der Aufbau entspricht im wesentlichen dem Aufbau des D/D-Wandlers der Figur 4, wobei jedoch aus dem 1-Bit-Signal am Ausgang des obersten Quantisierers $Q_0$ ein analoges Signal mit den beiden Spannungswerten $\pm$ $U_{ref}$ geformt werden muß. zur Ablegung der $2^n$ möglichen Werte der Summe $\Sigma c_i VZ_i$ ist wiederum eine Tabelle bzw. ein Digitalmultiplexer 11 vorgesehen.

**Patentansprüche**

1.  Sigma-Delta-Modulator zur Umwandlung eines analog oder digital vorliegenden, niederfrequenten Eingangssignals (X) hoher Auflösung in ein quantisiertes Analog- oder Digitalsignal (Y), mit einer Fehlerrückkoppelschaltung zur Unterdrückung von Quantisierungsfehlern,
    **dadurch gekennzeichnet,**
    daß er Mittel ($Z^{-1}$) zur Verzögerung des Eingangssignals (X) um i Abtastperioden zum Erhalt verzögerter Eingangssignale ($X_i$), wobei i=1,2,...n ist, Mittel (2) zur Addition der um i Abtastperioden verzögerten Eingangssignale ($X_i$) zum Erhalt eines Summensignals ($S_1$), Mittel (Q, $Q_0$, $Q_1$ bis $Q_n$, 3) zur Erzeugung quantisierter, um i Abtastperioden verzögerter Eingangssignale ($VZ_i$) und zur Addition der verzögerten, quantisierten Eingangssignale ($VZ_i$) zum Erhalt eines zweiten Summensignals ($S_2$), und Mittel (1) zur Subtraktion der Summensignale ($S_1$) und ($S_2$) von einem aktuellen Wert des Eingangssignals (X) aufweist.

2.  Sigma-Delta-Modulator nach Anspruch 1, gekennzeichnet durch Mittel ($d_1$ bis $d_n$) zur Multiplikation der um i Abtastperioden verzögerten Eingangssignale ($X_i$) jeweils mit Koeffizienten ($d_i$) einer Übertragungsfunktion des Sigma-Delta-Modulators, so daß das erste Summensignal ($S_1$) in der Form $S_1 = \Sigma d_i X_i$ darstellbar ist, und Mittel ($c_i$) zur Multiplikation der um i Abtastperioden verzögerten und quantisierten Eingangssignale $VZ_i$ jeweils mit Koeffizienten ($c_i$) der Übertragungsfunktion, so daß das zweite Summensignal ($S_2$) in der Form $S_2 = \Sigma c_i VZ_i$ darstellbar ist.

3.  Sigma-Delta-Modulator nach einem der Ansprüche 1 oder 2, gekennzeichnet durch Mittel (10, 11, 12) zur Ablegung bzw. Speicherung der $2^n$ möglichen Zustände des zweiten Summensignals ($S_2$) entsprechend der Übertragungsfunktion und der Wahl der Koeffizienten ($c_i$).

4.  Verfahren zur Unterdrückung eines Quantisierungsfehlers bei der Umwandlung eines analog oder digital vorliegenden, niederfrequenten Eingangssignals (X) hoher Auflösung in ein quantisiertes Analog- oder Digitalsignal (Y) in einem eine Fehlerrückkoppelschaltung aufweisenden Sigma-Delta-Modulator, mit folgenden Schritten:

    -   Quantisierung des Eingangssignals (X) entsprechend einer Abtastrate $f_a$ zu Zeitpunkten $t=m \cdot Ta$, wobei m=0,1,2... und Ta die Abtastperiode des Sigma-Delta-Modulators ist,
    -   Verzögerung des Eingangssignals (X) um i Abtastperioden zum Erhalt verzögerter Eingangssignale ($X_i$), wobei i=1,2,...n ist,
    -   Addition der um i Abtastperioden verzögerten Eingangssignale ($X_i$) zum Erhalt eines ersten Summensignals ($S_1$),

- Erzeugung quantisierter, um i Abtastperioden verzögerter Eingangssignale ($VZ_i$) und Addition der verzögerten, quantisierten Eingangssignale ($VZ_i$) zum Erhalt eines zweiten Summensignals ($S_2$), und Subtraktion der Summensignale ($S_1$) und ($S_2$) von einem aktuellen Wert des Eingangssignals (X).

FIG. 1

EP 1 001 538 A2

FIG. 2

FIG. 3

EP 1 001 538 A2

FIG. 4

EP 1 001 538 A2

FIG. 5